(19) **Europäisches Patentamt**

**European Patent Office**

**Office européen des brevets**

(11) **EP 1 463 196 B1**

(12) **FASCICULE DE BREVET EUROPEEN**

(45) Date de publication et mention
de la délivrance du brevet:
**07.12.2005 Bulletin 2005/49**

(51) Int Cl.⁷: **H03B 5/12**

(21) Numéro de dépôt: **04290694.1**

(22) Date de dépôt: **15.03.2004**

(54) **Oscillateur commandé en tension**

Spannungsgesteuerter Oszillator

Voltage controlled oscillator

(84) Etats contractants désignés:
**AT BE BG CH CY CZ DE DK EE ES FI FR GB GR
HU IE IT LI LU MC NL PL PT RO SE SI SK TR**

(30) Priorité: **28.03.2003 FR 0303898**

(43) Date de publication de la demande:
**29.09.2004 Bulletin 2004/40**

(73) Titulaire: **FRANCE TELECOM
75015 Paris (FR)**

(72) Inventeur: **Majos, Jacques
38420 Le Versoud (FR)**

(74) Mandataire: **Loisel, Bertrand et al
Cabinet Plasseraud
65/67 rue de la Victoire
75440 Paris Cedex 09 (FR)**

(56) Documents cités:
**EP-A- 1 187 308**          **US-A1- 2001 013 813**

## Description

L'invention concerne un oscillateur commandé en tension réalisé en technologie CMOS.

Plus particulièrement, l'invention concerne la synthèse de fréquences basée sur l'utilisation d'un oscillateur commandé en tension asservi par une fréquence de référence.

Une application particulièrement intéressante d'un tel oscillateur concerne le domaine des télécommunications pour la réalisation d'émetteurs ou de récepteurs radio, pour lesquels il est nécessaire d'engendrer des fréquences précises pour sélectionner un canal radio. Plus particulièrement, l'invention trouve une application particulièrement avantageuse dans le domaine des hautes fréquences, de l'ordre de 5 GHz, cette fréquence étant retenue dans certains réseaux locaux radio pour l'onde porteuse afin de ne pas perturber les réseaux voisins..

A chaque communication est attribué un canal contenu dans cette bande de fréquence, ayant une largeur d'environ 20 MHz. Il est donc nécessaire de disposer, en réception, d'un oscillateur local capable d'engendrer des fréquences précises pour sélectionner un canal donné. Un tel oscillateur, qui est destiné à être embarqué dans les terminaux de réception, doit nécessairement présenter un faible coût de production et un haut niveau d'intégration.

C'est la raison pour laquelle on réalise généralement ces oscillateurs en technologie CMOS. Selon cette technologie, les oscillateurs comportent par exemple deux circuits oscillants identiques comprenant chacun un circuit résonant de type LC, associés chacun à un inverseur constitué par l'association de deux transistors.

Comme on le conçoit, l'une des préoccupations majeures des fabricants de terminaux de télécommunications concerne la miniaturisation des composants électroniques embarqués. Ce problème se pose de manière accrue pour les selfs des oscillateurs constitutifs des circuits résonants, la surface de silicium utilisée pour la réalisation d'une self étant directement liée à la valeur de la self et donc à la fréquence d'oscillation. Il n'est donc pas possible de diminuer la taille de l'oscillateur sans modifier la valeur de la self et donc la fréquence de l'oscillateur.

C'est ainsi que, selon la technologie MOS, la surface de silicium nécessaire pour la réalisation des transistors de l'oscillateur est négligeable par rapport à la surface de silicium nécessaire pour la réalisation des selfs.

Le document EP 1 187 308 A2 décrit un oscillateur commandé en tension comportant un étage oscillant présentant une structure à deux inverseurs couplés réalisés en technologie CMOS ainsi que de deux circuits oscillants commandés en fréquence par une tension d'accord.

Le but de l'invention est donc de pallier les inconvénients des oscillateurs de l'état de la technique et de fournir un oscillateur commandé en tension ayant un niveau d'intégration accru.

Selon l'invention, il est donc proposé un oscillateur commandé en tension comprenant un étage oscillant à deux inverseurs CMOS couplés formant un quadripôle à deux entrées et à deux sorties, et deux circuits oscillants disposés respectivement entre les entrées et les sorties des inverseurs et comportant chacun une self, le quadripôle étant adapté pour que les sorties dudit quadripôle soient en phase.

Selon une caractéristique générale de l'oscillateur selon l'invention, les selfs des circuits oscillants sont réalisés en technologie MOS et sont superposées l'une sur l'autre.

La superposition des deux selfs permet dès lors de diminuer la surface occupée par l'oscillateur, d'un facteur pouvant aller jusqu'à 2.

Selon une autre caractéristique de l'invention, les selfs des circuits oscillants sont réalisées sous la forme de spirales implantées dans des niveaux de métallisation respectifs d'un circuit intégré.

Ainsi, par exemple, les selfs se présentent sous la forme de capacités en forme de spirale formées respectivement par implantation de métal dans les niveaux de métallisation qui sont isolés par une couche d'oxyde mince.

Selon une autre caractéristique de l'invention, chaque inverseur comporte deux transistors MOS de polarité opposée, disposés en ligne, l'entrée de l'inverseur étant située sur la grille de l'un des transistors ayant une première polarité et la sortie au point milieu des deux transistors.

En outre, l'entrée de chaque inverseur est reliée à la grille d'un transistor d'une deuxième polarité de l'autre inverseur, ladite deuxième polarité étant opposée à ladite première polarité.

L'oscillateur comporte en outre un étage d'amplification comprenant deux transistors MOS de polarité opposée disposés en série, la grille de chaque transistor étant reliée à l'une des sorties de l'étage oscillant.

D'autres buts, caractéristiques et avantages de l'invention apparaîtront à la lecture de la description suivante, donnée uniquement à titre d'exemple non limitatif, et faite en référence aux dessins annexés sur lesquels :

- la figure 1 est un schéma illustrant la réalisation d'un oscillateur commandé en tension conforme à l'invention ;
- la figure 2 est une vue en coupe d'une plaquette de circuit intégré illustrant la réalisation des selfs d'un oscillateur conforme à l'invention ; et
- la figure 3 est une vue de dessus de la plaquette de la figure 2.

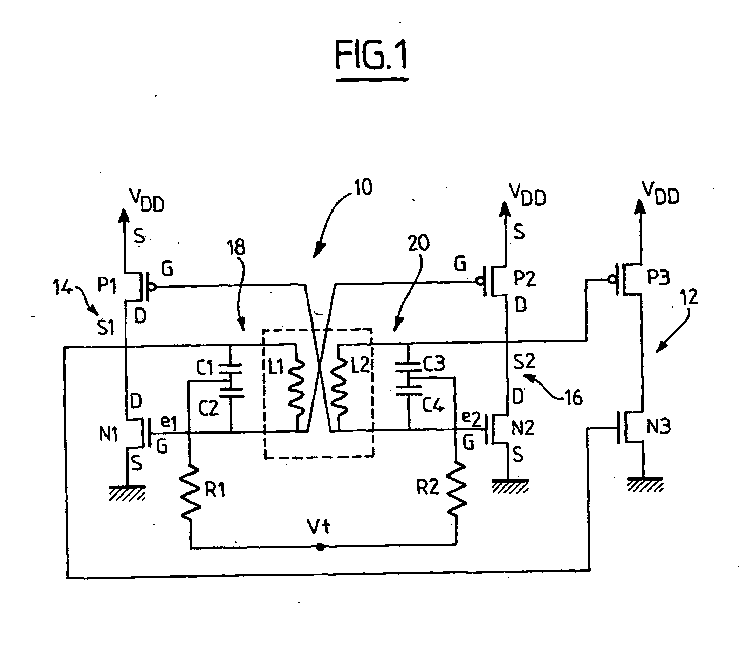

Sur la figure 1, on a représenté le circuit électronique d'un oscillateur commandé en tension conforme à l'invention.

Comme on le voit sur cette figure 1, l'oscillateur comporte un étage oscillant 10 associé à un étage amplificateur 12 de type "push-pull".

L'étage oscillant 10 constitue un quadripôle à deux entrées e1 et e2 et à deux sorties s1 et s2.

En particulier, l'étage oscillant 10 présente une structure à deux inverseurs 14 et 16 couplés, réalisés en technologie CMOS. Chaque inverseur 14 et 16 comporte deux transistors MOS, respectivement N1 et P1, et N2 et P2 de polarité opposée et disposés en série. En d'autres termes, l'un des inverseurs, à savoir l'inverseur désigné par la référence numérique générale 14, comporte un premier transistor MOS N1 de type N, et un deuxième transistor MOS P1 de type P couplés de sorte que la source S du transistor MOS N1 soit raccordé à la masse, que la source S du deuxième transistor P1 soit raccordé à une source de tension d'alimentation Vdd, et que le drain D du premier transistor N1 soit raccordé au drain du deuxième transistor P1.

Le câblage de l'autre inverseur 16 est réalisé de manière symétrique.

On voit sur la figure 1 que les deux entrées e1 et e2 du quadripôle 10 sont constituées par les grilles G des premiers transistors N1 et N2 des deux inverseurs 14 et 16, tandis que les sorties S1 et S2 sont constituées par les drains D des deux transistors N1, P1, d'une part, et N2, P2, d'autre part.

Ces sorties S1 et S2 sont raccordées à l'étage d'amplification 12.

Cet étage d'amplification 12 est constitué par l'association de deux transistors MOS N3 et P3 de polarité opposée disposés en série, dont les grilles respectives reçoivent les signaux de sortie s1 et s2 des deux inverseurs 14 et 16.

Cet étage d'amplification constitue un amplificateur de type push-pull conventionnel. Il ne sera donc pas décrit davantage par la suite.

Enfin, l'étage oscillant 10 est complété par deux circuits oscillants ou résonants 18 et 20, disposés en parallèle respectivement entre les entrées e1, e2 et les deux sorties s1, s2 des deux inverseurs 14 et 16. Comme le montre la figure 1, ces deux circuits oscillants 18 et 20 sont commandés en fréquence par une tension Vt d'accord à travers deux résistances R1 et R2. Chaque circuit oscillant 18 et 20 est formé d'une inductance L1, L2 et d'une capacité en parallèle réalisée par deux capacités C1, C2 et C3, C4 montées en série et dont le point milieu est piloté par la tension d'accord Vt.

Ces circuits oscillants 18 et 20 sont ainsi chacun constitués d'une self à induction associée à une capacité en parallèle, laquelle st successivement chargée puis déchargée à travers la self L1, L2, créant ainsi des oscillations dont la fréquence dépend de la valeur des capacités C1, C2 et C3, C4, de la valeur des selfs L1 et L2.

Comme indiqué précédemment, la réalisation des selfs en technologie CMOS présente des inconvénients majeurs en termes de surface de silicium nécessaire à la réalisation de ces composants.

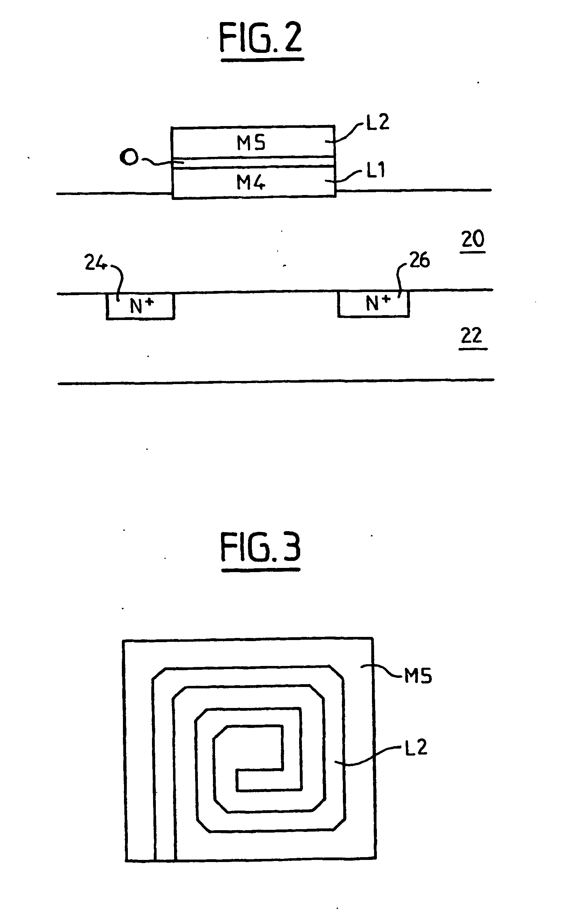

Conformément à une caractéristique de l'invention, comme on le voit sur la figure 2, les selfs L1 et L2 sont formées dans deux niveaux de métallisation M4 et M5 isolés par une couche d'oxyde mince O et sont superposées l'une sur l'autre, ce qui permet de réduire considérablement la surface de silicium nécessaire pour la réalisation de ces selfs.

On voit en effet sur la figure 2 que ces selfs L1 et L2 sont formées dans les deux derniers niveaux de métallisation M4 et M5 sur une couche d'oxyde de silicium 20 elle-même déposée sur un substrat 22 de type p, des caissons dopés de type N$^+$24 et 26 étant prévus, dans le substrat 20, de part et d'autre des selfs, afin de limiter les pertes de ces dernières.

Comme on le voit sur la figure 3, sur laquelle seul le niveau de métallisation supérieur M5 a été représenté, les selfs sont réalisées par implantation de métal sous la forme de spirales et constituent, conjointement, une capacité en spirale. Les deux selfs sont dès lors couplées en formant une capacité. La présence d'une telle capacité n'est cependant pas gênante puisque la différence de potentiel entre les selfs L1 et L2 est nulle.

De préférence, comme visible sur la figure 2, pour la réalisation des selfs, on utilise entre autre le dernier niveau de métallisation M5, qui a une épaisseur accrue.

On notera que la mutuelle inductance entre les deux selfs permet de modifier les propriétés de l'oscillateur.

En effet, dans une configuration de selfs empilées, si chaque self présente une valeur d'inductance L, en raison du couplage de ces deux selfs, la valeur L' de chaque inductance devient alors :

$$L'=L\ (1+k)$$

k désignant le coefficient de mutuelle inductance des deux selfs.

On conçoit dès lors qu'en utilisant une telle structure de selfs empilées pour l'implantation des selfs L1 et L2, si le coefficient k de mutuelle inductance est voisin de 1, la valeur de l'inductance de chaque self est doublée, ce qui permet de diminuer par deux le diamètre de chaque self.

On notera enfin que selon une particularité du montage des deux inverseurs 14 et 16, du point de vue du câblage de ces inverseurs, ceux-ci ne sont pas formés puisque les grilles des transistors N1 et P1, d'une part, et N2 et P2, d'autre part, ne sont pas interconnectées à un même point. Cependant, le quadripôle 10, dont les entrées et les sorties correspondent aux entrées e1, e2 et aux sorties s1, s2 des inverseurs, présente un gain maximal quand les entrées e1 et e2 sont en phase. En d'autres termes, lorsque le quadripôle 10 a atteint son point de fonctionnement nominal défini par le gain maximum, les entrées e1 et e2 sont en phase et, de ce fait, les inverseurs 14 et 16 sont fonctionnellement fermés. On notera également que, dans ce cas, les sorties s1 et s2 sont également en phase, ce qui permet d'attaquer directement l'étage d'amplification 12.

**Revendications**

1.  Oscillateur commandé en tension, comprenant un étage oscillant à deux inverseurs CMOS (14, 16) couplés formant un quadripôle à deux entrées (e1, e2) et à deux sorties (s1, s2), et deux circuits oscillant (18, 20) disposés respectivement entre les entrées et les sorties des inverseurs et comportant chacun une self (L1, L2), le quadripôle étant adapté pour que les sorties dudit quadripôle soient en phase, **caractérisé en ce que** les selfs (L1, L2) des circuits oscillants sont réalisées en technologie MOS et sont superposées l'une sur l'autre.

2.  Oscillateur selon la revendication 1, **caractérisé en ce que** les selfs des circuits oscillants sont réalisées sous la forme de spirales implantées dans des niveaux de métallisation (M4, M5) respectifs d'un circuit intégré.

3.  Oscillateur selon la revendication 2, **caractérisé en ce que** les selfs se présentent sous la forme de capacités en forme de spirale formées respectivement par implantation de métal dans lesdits niveaux de métallisation (M4, M5) qui sont isolés par une couche d'oxyde mince (O).

4.  Oscillateur selon l'une quelconque des revendications 1 à 3, **caractérisé en ce que** chaque inverseur comporte deux transistors (N1, P1, N2, P2) MOS de polarité opposée, disposés en ligne, l'entrée de l'inverseur (e1, e2) étant située sur la grille (G) de l'un des transistors ayant une première polarité et la sortie (S1, s2) au point milieu des deux transistors.

5.  Oscillateur selon la revendication 4, **caractérisé en ce que** l'entrée (e1, e2) de chaque inverseur est reliée à la grille (G) d'un transistor d'une deuxième polarité de l'autre inverseur, ladite deuxième polarité étant opposée à ladite première polarité.

6.  Oscillateur selon l'une quelconque des revendications 1 à 5, **caractérisé en ce qu'**il comporte en outre un étage d'amplification (12) comprenant deux transistors MOS (N3, P3) de polarité opposée disposés en série, la grille de chaque transistor MOS étant reliée à l'une des sorties de l'étage oscillant.

**Patentansprüche**

1.  Spannungsgeregelter Oszillator, umfassend eine oszillierende Stufe mit zwei gekoppelten CMOS-Invertern (14, 16), welche einen Quadrupol mit zwei Eingängen (e1, e2) und zwei Ausgängen (s1, s2) bilden, und zwei oszillierende Schaltungen (18, 20), welche jeweils zwischen den Eingängen und Ausgängen der Inverter angeordnet sind und wobei jede eine Drosselspule (L1, L2) umfasst, wobei der Quadrupol dafür eingerichtet ist, dass die Ausgänge des Quadrupols phasengleich sind, **dadurch gekennzeichnet, dass** die Drosselspulen (L1, L2) der oszillierenden Schaltungen in MOS-Technologie realisiert sind und übereinander angeordnet sind.

2.  Oszillator nach Anspruch 1, **dadurch gekennzeichnet, dass** die Drosselspulen der oszillierenden Schaltungen in From von Spiralen realisiert sind, welche in jeweiligen Metallisierungsbereichen (M4, M5) einer integrierten Schaltung eingesetzt sind.

3.  Oszillator nach Anspruch 2, **dadurch gekennzeichnet, dass** die Drosselspulen als spiralförmige C-Glieder ausgebildet sind, welche jeweils durch Einsetzen von Metall in die Metallisierungsbereiche (M4, M5) gebildet sind, die durch eine dünne Oxydschicht (O) isoliert sind.

4.  Oszillator nach einem der Ansprüche 1 bis 3, **dadurch gekennzeichnet, dass** jeder Inverter zwei in Serie angeordnete MOS-Transistoren (N1, P1, N2, P2) mit entgegengerichteter Polarität umfasst, wobei sich der Eingang des Inverters (e1, e2) auf dem Gate (G) des einen der Transistoren befindet, welcher eine erste Polarität aufweist, und wobei sich der Ausgang (S1, S2) in der Mitte der zwei Transistoren befindet.

5.  Oszillator nach Anspruch 4, **dadurch gekennzeichnet, dass** der Eingang (e1, e2) jedes Inverters mit dem Gate (G) eines Transistors mit einer zweiten Polarität des anderen Inverters verbunden ist, wobei die zweite Polarität zur ersten Polarität entgegengerichtet ist.

6.  Oszillator nach einem der Ansprüche 1 bis 5, **dadurch gekennzeichnet, dass** er ferner eine Verstärkerstufe (12) umfasst, welche zwei in Serie angeordnete MOS-Transistoren (N3, P3) mit entgegengerichteter Polarität aufweist, wobei das Gate jedes MOS-Transistors mit einem der Ausgänge der oszillierenden Stufe verbunden ist.

## Claims

**1.** A voltage-controlled oscillator, comprising an oscillating stage with two coupled CMOS inverters (14, 16) forming a quadrupole with two inputs (e1, e2) and with two outputs (s1, s2), and two oscillating circuits (18, 20) respectively placed between the inputs and the outputs of the inverters and each comprising an inductor (L1, L2), the quadrupole being configured such that the outputs of the quadrupole are in phase, **characterized in that** the inductors (L1, L2) of the oscillating circuits are produced in MOS technology and are superposed one on top of the other.

**2.** The oscillator according to claim 1, **characterized in that** the inductors of the oscillating circuits are produced in the form of spirals implanted in respective metallization levels (M4, M5) of an integrated circuit.

**3.** The oscillator according to claim 2, **characterized in that** the inductors are in the form of spiraled capacitors respectively formed by metal implantation in said metallization levels (M4, M5) that are isolated by a thin oxide film (O).

**4.** The oscillator according to any one of claims 1 to 3, **characterized in that** each inverter comprises two oppositely biased MOS transistors (N1, P1, N2, P2) placed in line, the input of the inverter (e1, e2) being located on the gate (G) of one of the transistors having a first bias and the output (s1, s2) at the midpoint of the two transistors.

**5.** The oscillator according to claim 4, **characterized in that** the input (e1, e2) of each inverter is coupled to the gate (G) of a transistor with a second bias of the other inverter, said second bias being opposite said first bias.

**6.** The oscillator according to claim 1, **characterized in that** it further comprises an amplification stage (12) having two oppositely biased MOS transistors (N3, P3) placed in series, the gate of each MOS transistor being coupled to one of the outputs of the oscillating stage.

# FIG.1

## FIG.2

## FIG.3